# EUROPÄISCHE PATENTSCHRIFT

(11) **EP 2 392 027 B1**
(45) Veröffentlichungstag und Bekanntmachung des Hinweises auf die Patenterteilung: **23.10.2019**
(21) Anmeldenummer: 10702270.9
(22) Anmeldetag: 25.01.2010
(51) Int. Cl.: H01L 23/36, H01L 23/373, H01L 23/473

(54) **VERBUNDBAUTEIL**
COMPOSITE COMPONENT
PIÈCE COMPOSITE

(30) Priorität: 30.01.2009 DE 102009000514
(43) Veröffentlichungstag der Anmeldung: 07.12.2011
(73) Patentinhaber: Robert Bosch GmbH, 70442 Stuttgart (DE)
(72) Erfinder: HIRSCH, Michele, 73730 Esslingen (DE); GUENTHER, Michael, 70469 Stuttgart (DE)
(86) Internationale Anmeldenummer: PCT/EP2010/050771
(87) Internationale Veröffentlichungsnummer: WO 2010/086282

(56) Entgegenhaltungen:
- EP-A2- 1 995 773
- EP-A2- 1 995 774
- WO-A1-98/03997
- US-A- 4 739 443
- US-A- 5 043 796
- US-A- 5 142 441
- US-A- 5 754 403
- US-A1- 2002 125 563
- US-A1- 2002 185 726
- US-A1- 2006 023 436
- US-B1- 6 284 985
- US-B2- 7 219 826

## Beschreibung

### Stand der Technik

Die Erfindung betrifft ein Verbundbauteil, umfassend einen ersten und mindestens einen zweiten Fügepartner gemäß dem Oberbegriff des Anspruchs 1. Bevorzugt handelt es sich bei dem ersten Fügepartner um ein Elektronikelement, insbesondere einen Leistungshalbleiter oder um einen, insbesondere bestückten, vorzugsweise mit einem Leistungshalbleiter bestückten Schaltungsträger und bei dem zweiten Fügepartner um eine Wärmesenke. Ferner betrifft die Erfindung ein Verfahren zum Herstellen eines Verbundbauteils gemäß dem Oberbegriff des Anspruchs 13.

Derzeit werden für Automotive-Anwendungen elektrische Schaltungen, mit hohen Verlustleistungen, wie Leistungsschaltungen oder B-, H-Brücken auf DBC- oder AMB-Substraten mittels Wärmeleitkleber an eine Wärmesenke angebunden. Die dissipierte Wärmemenge des Halbleiters der elektrischen Schaltung wird durch den Schaltungsträger und den die Fügestelle bildenden Wärmeleitkleber in eine Grundplatte oder ein Gehäuse geführt, um Wärme von dem mindestens einen elektronischen Bauelement abzuführen und dieses somit geeignet zu kühlen. Die Grundplatte oder das Gehäuse wiederum können passiv oder aktiv, insbesondere durch ein strömendes Medium, gekühlt werden. Bei dem zuvor beschriebenen Verbundbauteil ist nachteilig, dass die von dem Wärmeleitkleber gebildete Fügeschicht einen merklichen Engpass für die Wärmeableitung schon bei relativ kurzen zeitlichen Pulsbelastungen darstellt. Eine Alternative dazu bietet die Anbindung des bestückten Schaltungsträgers an die Wärmesenkung mittels eines Lotwerkstoffes, der ein höheres Wärmeleitvermögen besitzt als Wärmeleitkleber. Nachteilig hieran ist jedoch, dass durch die thermomechanische Belastung des Verbundbauteils im Betrieb eine Zerrüttung des Lotes auftreten kann. Dies hat zur Folge, dass eine Anbindung mit einem Lotwerkstoff aufgrund von Lebensdaueranforderungen häufig nicht sinnvoll ist bzw. dass nur sehr kleine Flächen über einen Lotwerkstoff angebunden werden können.

In der Patentschrift US 4739443 ist beispielsweise Elektronikmodul offenbart, welches zwei einseitig bestückte Substrate aufweist, die über eine Verbindungsschicht an ihren jeweils unbestückten Substratseite zu einem Verbund miteinander verbunden sind.

In der Offenlegungsschrift WO98/03997 A1 ist ein gekühltes Keramiksubstrat gezeigt. Auf diesem ist oberseitig ein Heatsinkelement angeordnet und bodenseitig eine Halteplatte. Die Halteplatte hat Zugänge für eine Kühlflüssigkeit und verbindet einen Mikrokühlkanal, welcher durch die Halteplatte, das Keramiksubstrat und das Heatsinkelement verläuft.

Die Offenlegungsschrift US020020125563A1 zeigt ein Leistungsmodul, umfassend ein keramisches Trägersubstrat mit beidseitigen Beschichtungen. Mit den Beschichtungen sind Leistungshalbleiter kontaktiert.

### Offenbarung der Erfindung

Der Erfindung liegt daher die Aufgabe zugrunde, ein Verbundbauteil anzugeben, das sich durch eine gute Temperaturwechselbeständigkeit und/oder Wärmeableitung auszeichnet.

Diese Aufgabe wird hinsichtlich des Verbundbauteils mit den Merkmalen des Anspruchs 1 gelöst. Vorteilhafte Weiterbildungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen. Zur Vermeidung von Wiederholungen sollen vorrichtungsgemäß offenbarte Merkmale auch als verfahrensgemäß offenbart gelten und beanspruchbar sein. Ebenso sollen verfahrensgemäß offenbarte Merkmale als vorrichtungsgemäß offenbart gelten und beanspruchbar sein.

Der Erfindung liegt der Gedanke zugrunde, zwei Fügepartner nicht wie im Stand der Technik mit einer einzigen Fügeschicht miteinander zu verbinden, sondern mit mindestens zwei, vorzugsweise ausschließlich zwei, Fügeschichten, zwischen denen mindestens eine, vorzugsweise ausschließlich eine, weitere Schicht, nämlich eine Zwischenschicht, angeordnet ist. Dabei haben die Fügeschichten die Aufgabe, den jeweiligen Fügepartner fest mit der Zwischenschicht zu verbinden, und für die notwendige elektrische und/oder mechanische und/oder thermische Anbindung der Fügepartner an die Zwischenschicht zu sorgen. Dabei handelt es sich, wie später noch erläutert werden wird, bei zumindest einer der Fügeschichten, ganz besonders bevorzugt bei beiden Fügeschichten, um eine Sinterschicht, insbesondere mit metallischen Sinterpartikeln zur Gewährleistung einer elektrischen, thermischen und mechanischen Anbindung der Fügepartner, an die vorzugsweise elektrisch und/oder thermisch leitende Zwischenschicht. Als Zwischenschicht kann beispielsweise Silizium zur Anwendung kommen. Zusätzlich oder alternativ ist mindestens eine der Fügeschichten als Kleberschicht oder Lotschicht ausgebildet.

Die Erfindung lässt sich beispielsweise anwenden bei Leistungsendstufen von elektrischen Servolenkungen, bei Leistungsendstufen universeller Wechselrichtereinheiten, insbesondere in Hybridfahrzeug-Anwendungen oder Elektrofahrzeug-Anwendungen, bei Leistungsschaltungen in DC/DC-Wandlern, insbesondere für Hybrid-Anwendungen, in Reglerelektroniken, insbesondere am Starter/Generator, bei Einpressdioden an Generatorschilden, bei hochtemperaturstabilen Halbleitern, wie beispielsweise Siliziumkarbid, oder auch bei Sensoren, die unter hoher Temperatur betrieben werden und eine sensornahe Auswerteelektronik benötigen, sowie in Modulen für Wechselrichter an Photovoltaikanlagen. Weitere Anwendungen sind ebenfalls möglich.

Bevorzugt ist die Zwischenschicht derart gewählt, dass deren thermischer Ausdehnungskoeffizient gering ist, um somit die Temperaturwechselbeständigkeit des Verbundbauteils zu optimieren. Ganz besonders bevorzugt entspricht das Ausdehnungsverhalten der Zwischenschicht zumindest näherungsweise dem Ausdehnungsverhalten mindestens eines der Fügepartner, vorzugsweise eines Halbleiters, insbesondere auf dessen Schaltungsseite, wobei auch eine Differenz der Ausdehnungskoeffizienten akzeptabel ist - diese sollte jedoch so gering wie möglich sein. Durch das Vorsehen der Zwischenschicht mit einem geringen thermischen Ausdehnungskoeffizienten, der vorzugsweise ähnlich dem thermischen Ausdehnungskoeffizienten eines der Fügepartner ist, wird die Temperaturwechselbeständigkeit des Verbundbauteils erhöht. Weiterhin kommt es zu einer zusätzlichen Spreizung von Wärmepulsen.

Wie bereits angedeutet, ist in Weiterbildung der Erfindung mit Vorteil vorgesehen, dass der thermische Ausdehnungskoeffizient der Zwischenschicht, zumindest näherungsweise, dem thermischen Ausdehnungskoeffizienten des ersten und/oder zweiten Fügepartners entspricht. Ganz besonders bevorzugt entspricht der thermische Ausdehnungskoeffizient der Zwischenschicht einem als Fügepartner dienenden elektrischen und/oder elektronischen Bauteil, vorzugsweise einem Halbleiter, ganz besonders bevorzugt einem Leistungshalbleiter, weiter bevorzugt auf dessen Schaltungsseite. Noch weiter bevorzugt entspricht das Zwischenschichtmaterial dem oder einem Material des elektrischen und/oder elektronischen Bauteils.

Beide Fügepartner sind über ausschließlich drei Schichten miteinander verbunden, nämlich der ersten, den ersten Fügepartner unmittelbar kontaktierenden Fügeschicht, der zweiten, den zweiten Fügepartner unmittelbar kontaktierenden Fügeschicht und der zwischen den Fügeschichten angeordneten Zwischenschicht.

Dabei ist zumindest eine der Fügeschichten, vorzugsweise beide Fügeschichten, als Sinterschicht ausgebildet, wobei die Zwischenschicht lateral strukturiert ist, um somit jeweils nur begrenzte Flächen an die mindestens eine metallische Sinterschicht anzubinden. Hierdurch können temperaturwechselbedingte mechanische Spannungen auf ein Minimum reduziert werden. Zusätzlich oder alternativ zu einer lateralen Strukturierung der Zwischenschicht ist es möglich, die erste und/oder die zweite Fügeschicht lateral zu strukturieren. Ganz besonders bevorzugt werden/wird die Zwischenschicht und/oder die erste und/oder die zweite Fügeschicht bereits strukturiert aufgebracht, ganz besonders bevorzugt in voneinander lateral beabstandeten Flächenabschnitten.

Ferner ist der erste Fügepartner ein Elektronikbauteil, welches insbesondere ein Halbleiterbauelement, vorzugsweise ein Leistungshalbleiterbauelement, ist oder umfasst. Ganz besonders bevorzugt handelt es sich um einen mit mindestens einem Elektronikbauteil bestückten Schaltungsträger, der weiter bevorzugt unmittelbar über die erste Fügeschicht mit der Zwischenschicht verbunden ist.

Des Weiteren ist der zweite Fügepartner eine Wärmesenke, insbesondere eine Grundplatte, ein Kühlkörper oder ein Gehäuse, wobei es noch weiter bevorzugt ist, wenn dieser zweite Fügepartner unmittelbar über die zweite Fügeschicht mit der Zwischenschicht, die ganz besonders bevorzugt aus Silizium ausgebildet ist, verbunden ist.

Weiter bevorzugt ist es, wenn die erste und/oder die zweite Fügeschicht und/oder die Zwischenschicht derart strukturiert ist/sind, dass zwischen den Strukturabschnitten der jeweiligen Schicht mindestens ein Fluidkanal, vorzugsweise ein Fluidkanalnetz, gebildet ist, dass dazu geeignet und bestimmt ist, dass durch dieses ein Kühlfluid, insbesondere Kühlgas oder Kühlflüssigkeit, geleitet werden kann, um auf diese Weise zusätzlich Wärme aus dem Verbundbauteil abzutransportieren. Ganz besonders bevorzugt ist es dabei, wenn der Fluidkanal oder das Fluidkanalnetz innerhalb der Zwischenschicht zwischen Strukturabschnitten der Zwischenschicht gebildet ist. Anders ausgedrückt wird zumindest eine der Verbindungsschichten derart strukturiert, dass Hohlräume entstehen, durch die ein Kühlfluid geleitet werden kann, um dem gesamten Aufbau Wärme zu entziehen. Im einfachsten Fall kann dies ein Gas sein. Das Durchströmen mit einer Kühlflüssigkeit hat den Vorteil, dass eine höhere Wärmemenge pro Zeit aufgenommen werden kann.

In Weiterbildung der Erfindung ist mit Vorteil vorgesehen, dass Mittel zum Beaufschlagen des Fluidkanals und/oder des Fluidkanalnetzes mit einem Fluid vorgesehen sind. Dabei kann es sich im einfachsten Fall um eine Lüfteranordnung handeln, mit der Luft durch den Fluidkanal bzw. das Fluidkanalnetz geblasen und/oder gesaugt wird. Im Falle des Vorsehens einer Kühlflüssigkeit ist es bevorzugt, wenn die Mittel zum Beaufschlagen des Fluidkanals und/oder des Fluidkanalnetzes mindestens eine Pumpe umfassen.

Im Hinblick auf die Ausbildung der Fügeschichten gibt es unterschiedliche Möglichkeiten. Wie eingangs bereits angedeutet, ist es besonders, wenn zumindest eine der Fügeschichten, vorzugsweise beide Fügeschichten, als Sinterschicht, insbesondere mit metallischen Sinterpartikeln, ausgebildet sind/ist, um somit eine optimale thermische und elektrische Anbindung der Fügepartner an die Zwischenschicht zu erreichen. Zusätzlich oder alternativ ist mindestens eine der Fügeschichten als Kleberschicht oder Lotschicht ausgebildet, insbesondere unter Verwendung von bleifreiem Lot. Auch ist es möglich, die Zwischenschicht als durch Legieren hergestellte Gradienten-Schicht oder als durch Schweißen erzeugte Schicht auszubilden. Ganz besonders bevorzugt ist es, wenn zumindest eine der Schichten, also die erste und/oder die zweite Fügeschicht und/oder die Zwischenschicht, mikro- und/oder nanostrukturiert ist, dass also beispielsweise Pyramidenstrukturen, Kanäle oder ähnliche Strukturen, wie sie beispielsweise bei Solarzellen als Lichtfallen Anwendung finden, realisiert sind, um somit die Fläche für den Wärmeübergang in das Kühlfluid zu vergrößern. Auch ist es möglich, einen Fügepartner, vorzugsweise eine Wärmesenke, zur verbesserten Temperaturableitung makroskopisch zu strukturieren.

Besonders zweckmäßig ist eine Ausführungsform, bei der in die erste und/oder zweite Fügeschicht und/oder (was bevorzugt ist) in die Zwischenschicht mindestens ein Sensor eingebracht ist, ganz besonders ein Temperatursensor. Dieser misst dann zwar nicht direkt an der heißesten Stelle eines Fügepartners, insbesondere eines Halbleiters, die Temperatur, sondern darunter. Dies hat den Vorteil, dass am Schaltungsträger eine Platzersparnis realisierbar ist und/oder auf zusätzliche kostspielige Halbleiterfläche verzichtet werden kann. Ganz besonders bevorzugt ist es, wenn der mindestens eine Sensor, vorzugsweise der Temperatursensor, mittels einer Durchkontaktierung mit einem Fügepartner, insbesondere einem Schaltungsträger, elektrisch leitend verbunden ist.

Nachfolgend ist beispielsweise ein Verfahren zum Herstellen eines Verbundbauteils, vorzugsweise eines wie zuvor beschrieben ausgebildeten Verbundbauteils, ausgeführt. Das Verfahren zeichnet sich dadurch aus, dass die mindestens zwei, vorzugsweise ausschließlich zwei Fügepartner über mindestens drei, vorzugsweise ausschließlich drei, Schichten, nämlich eine erste und eine zweite Fügeschicht sowie eine dazwischen angeordnete Zwischenschicht miteinander gefügt werden. Im Hinblick auf die Ausbildung der Fügeschichten gibt es, wie zuvor anhand des Verbundbauteils beschrieben, unterschiedliche Möglichkeiten. So kann zumindest eine der Fügeschichten als Sinterschicht, Kleberschicht oder Lotschicht ausgebildet werden. Auch im Hinblick des Aufbringens der Schichten auf zumindest einen der Fügepartner gibt es unterschiedliche Möglichkeiten. So ist eine Ausführungsform denkbar, bei der die mindestens drei, vorzugsweise ausschließlich drei, Schichten nacheinander auf einen der Fügepartner aufgetragen werden, woraufhin der weitere Fügepartner auf die drei Schichten aufgebracht wird. Auch ist es denkbar, dass jeder Fügepartner mit einer Fügeschicht versehen wird, woraufhin auf eine der Fügeschichten die Zwischenschicht aufgetragen wird.

Im Hinblick auf vorteilhafte Ausführungsformen und Weiterbildungen des Verfahrens wird auf die vorangehende Beschreibung des Verbundbauteils verwiesen, aus der sich vorteilhafte Ausgestaltungen des Verfahrens ableiten lassen.

Weitere Vorteile, Merkmale und Einzelheiten der Erfindung ergeben sich aus der nachfolgenden Beschreibung bevorzugter Ausführungsbeispiele sowie anhand der Zeichnungen.

Diese zeigen in:
- Fig. 1:: ein Beispiel für eine Verbundbauteil mit unstrukturierten Fügeschichten sowie einer unstrukturierten Zwischenschicht,
- Fig. 2:: ein erstes Ausführungsbeispiel eines erfindungsgemäßen Verbundbauteils, bei dem die Zwischenschicht lateral strukturiert ist,
- Fig. 3 - Fig. 5:: unterschiedliche Strukturierungsformen zur Strukturierung der ersten und/oder zweiten Fügeschicht und/oder der Zwischenschicht und
- Fig. 6:: ein weiteres alternatives Ausführungsbeispiel eines Verbundbauteils, bei dem in der Zwischenschicht ein Sensor vorgesehen ist, der durch die erste Fügeschicht durchkontaktiert, d.h. mit dem ersten Fügepartner elektrisch leitend verbunden ist.

In den Figuren sind gleiche Elemente und Elemente mit der gleichen Funktion mit den gleichen Bezugszeichen gekennzeichnet.

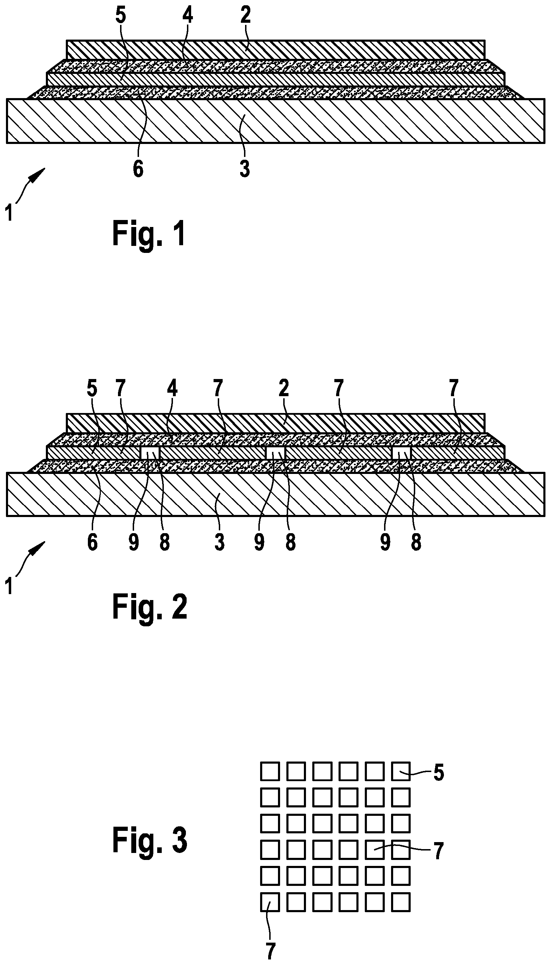

In Fig. 1 ist zur allgemeinen Anschauung ein Beispiel für ein Verbundbauteil 1 gezeigt. Zu erkennen sind ein erster und ein zweiter Fügepartner 2, 3, die über eine Schichtanordnung miteinander mechanisch, thermisch und elektrisch verbunden sind. Bei dem ersten Fügepartner 2 handelt es sich beispielsweise um einen, mit mindestens einem Leistungshalbleiter bestückten, Schaltungsträger und bei dem zweiten Fügepartner 3 um eine Wärmesenke, insbesondere eine Grundplatte, einen Kühlkörper, eine Kombination aus Grundplatte und Kühlkörper und/oder um ein Gehäuse.

Zu erkennen ist die vorerwähnte Schichtanordnung zwischen den beiden Fügepartnern 2, 3. Diese besteht aus einer ersten Fügeschicht 4, einer die erste Fügeschicht 4 unmittelbar kontaktierenden Zwischenschicht 5, welche wiederum unmittelbar eine zweite Fügeschicht 6 kontaktiert, die wiederum den zweiten Fügepartner 3 unmittelbar mit der Zwischenschicht 5 verbindet. Die beiden Fügeschichten 4, 6 sind beispielsweise identisch ausgebildet, können jedoch, je nach Anwendungszweck, auch unterschiedlich ausgebildet sein. Beispielsweise handelt es sich sowohl bei der ersten als auch bei der zweiten Fügeschicht, 4, 6 um eine Sinterschicht mit metallischen Sinterpartikeln. Die Zwischenschicht 5, die in dem gezeigten Ausführungsbeispiel aus Silizium ausgebildet ist, zeichnet sich dadurch aus, dass deren Wärmeausdehnungskoeffizient dem Wärmeausdehnungskoeffizient des mit dem Schaltungsträger verbundenen Halbleiters auf der Schaltungsseite entspricht.

Das erfindungsgemäße Verbundbauteil 1 gemäß Fig. 2 unterscheidet sich von dem zuvor beschriebenen und in Fig. 1 gezeigten beispielhaften Verbundbauteil 1 dadurch, dass die Zwischenschicht 5 lateral strukturiert ist, derart, dass zwischen lateral beabstandeten Strukturabschnitten 7 Hohlräume 8 gebildet sind, die miteinander vernetzt sind und somit ein Fluidkanalnetz 9 bilden, durch das Kühlfluid, insbesondere Kühlgas oder Kühlflüssigkeit, geleitet werden kann. Je kleiner die Strukturabschnitte 7 gewählt werden, desto kleiner ist die absolute Anbindungsfläche und desto besser ist die Temperaturwechselbeständigkeit.

Fig. 3 bis 5 zeigen - nicht abschließend - unterschiedliche Möglichkeiten zur Strukturierung einer der Schichten der Verbindungsschichtanordnung. Bevorzugt wird die mittlere Zwischenschicht 5 derart strukturiert. Zu erkennen ist, dass die Strukturabschnitte 7 bei dem Ausführungsbeispiel gemäß Fig. 3 quadratisch konturiert und in regelmäßigen Reihen und Spalten angeordnet sind.

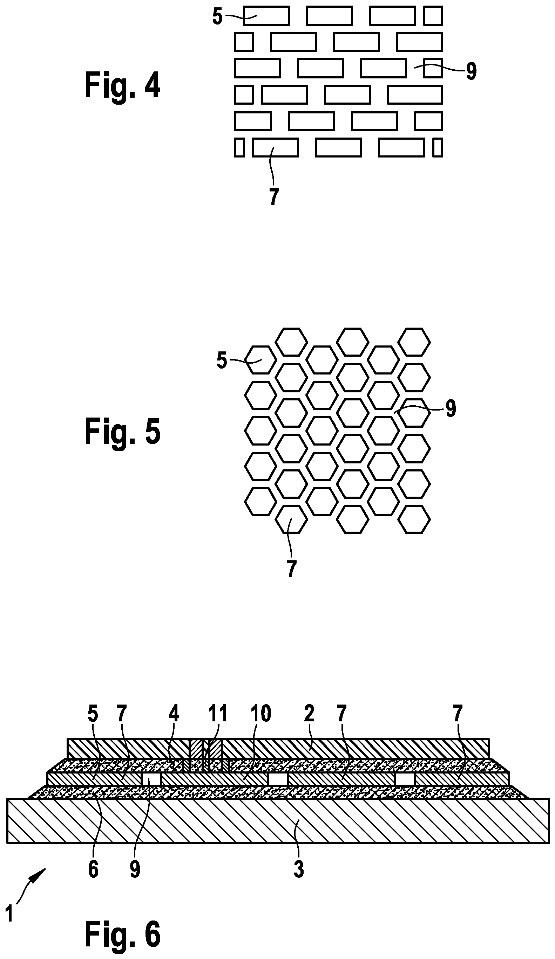

Bei dem Ausführungsbeispiel gemäß Fig. 4 sind die Strukturabschnitte 7 rechteckig konturiert, weisen also eine größere Längs- als Breitenerstreckung auf und sind in der Art eines Ziegelmauermusters angeordnet.

Bei dem Ausführungsbeispiel gemäß Fig. 5 sind die Strukturabschnitte 7 sechseckig (bienenwabenförmig) konturiert und angeordnet.

Fig. 6 zeigt ein weiteres alternatives Ausführungsbeispiel eines Verbundbauteils 1, umfassend einen ersten und einen zweiten Fügepartner 2, 3, die über eine Schichtanordnung, umfassend eine erste und eine zweite Fügeschicht 4, 6 sowie eine sandwichartig dazwischen aufgenommene Zwischenschicht 5, miteinander verbunden sind. Wie bei dem Ausführungsbeispiel gemäß Fig. 2 ist die Zwischenschicht 5 derart strukturiert, dass zwischen lateral beabstandeten Strukturabschnitten 7 ein Fluidkanalnetz 9 ausgebildet ist, durch das Kühlfluid geleitet werden kann. Das Ausführungsbeispiel gemäß Fig. 6 zeichnet sich dadurch aus, dass in die Zwischenschicht 5 ein als Temperatursensor ausgebildeter Sensor 10 integriert ist, der mittels Durchkontaktierungen 11 elektrisch leitend mit dem ersten Fügepartner 2 verbunden ist. Mittels des Sensors 10 kann die Temperatur des ersten Fügepartners 2 gemessen, insbesondere überwacht, werden.

Bei Bedarf kann der als Wärmesenke ausgebildete zweite Fügepartner 3 makrostrukturiert werden (nicht dargestellt), um die Temperatur verbessert ableiten zu können. Bevorzugt umfasst der zweite Fügepartner 3 hierzu Kühlrippen.

## Patentansprüche

1. Verbundbauteil mit einem ersten Fügepartner (2), mit mindestens einem zweiten Fügepartner (3) und mit einer ersten, zwischen dem ersten Fügepartner (2) und dem zweiten Fügepartner (3) angeordneten ersten Fügeschicht (4), wobei zusätzlich zu der ersten Fügeschicht (4) mindestens eine zweite Fügeschicht (6) zwischen dem ersten und dem zweiten Fügepartner (2, 3) vorgesehen ist, wobei zwischen der ersten und der zweiten Fügeschicht (4, 6) mindestens eine Zwischensicht (5) angeordnet ist, wobei die Zwischenschicht (5) lateral strukturiert ist, derart, dass Strukturabschnitte (7) der Zwischenschicht (5) lateral beabstandet sind, wobei zwischen den Strukturabschnitten (7) Hohlräume (8) gebildet sind, die miteinander vernetzt sind, und wobei der erste Fügepartner (2) ein Elektronikbauteil, insbesondere ein Halbleiterelement, vorzugsweise ein Leistungshalbleiterelement, und/oder ein insbesondere bestückter Schaltungsträger ist,
**dadurch gekennzeichnet,**
**dass** die erste Fügeschicht (4) den ersten Fügepartner (2) unmittelbar mit der Zwischensicht (5) und die zweite Fügeschicht (6) den zweiten Fügepartner (3) unmittelbar mit der Zwischenschicht (5) verbindet, dass die erste und/oder die zweite Fügeschicht (4, 6) als Sinterschicht, Kleberschicht, Lotschicht oder Elastomerdichtungsmaterial ausgebildet ist/sind, und dass der zweite Fügepartner (3) ein Schaltungsträger oder eine Wärmesenke, insbesondere eine Grundplatte, ein Kühlkörper oder ein Gehäuse ist.

2. Verbundbauteil nach Anspruch 1,
**dadurch gekennzeichnet,**
**dass** der thermische Ausdehnungskoeffizient der Zwischenschicht (5) zumindest näherungsweise dem thermischen Ausdehnungskoeffizienten des ersten und/oder zweiten Fügepartners (2, 3) entspricht.

3. Verbundbauteil nach einem der vorhergehenden Ansprüche,
**dadurch gekennzeichnet,**
**dass** die erste und/oder die zweite Fügeschicht (4, 6) lateral strukturiert ist.

4. Verbundbauteil nach Anspruch 3,
**dadurch gekennzeichnet,**
**dass** lateral zwischen Strukturabschnitten (7) der ersten und/oder zweiten Fügeschicht (4, 6) und/oder der Zwischenschicht (5) ein Fluidkanal und/oder Fluidkanalnetz (9) zum Durchleiten eines Kühlfluids ausgebildet ist.

5. Verbundbauteil nach Anspruch 4,
**dadurch gekennzeichnet,**
**dass** Mittel zum Beaufschlagen des Fluidkanals und/oder des Fluidkanalnetzes (9) mit einem Fluid, insbesondere einem Kühlgas oder einer Kühlflüssigkeit, vorgesehen sind.

6. Verbundbauteil nach einem der vorhergehenden Ansprüche,
**dadurch gekennzeichnet,**
**dass** die erste und/oder die zweite Fügeschicht (4, 6) und/oder die Zwischenschicht (5) mikro- und/oder nanostrukturiert ist.

7. Verbundbauteil nach einem der vorhergehenden Ansprüche,
**dadurch gekennzeichnet,**
**dass** in der ersten und/oder zweiten Fügeschicht (4, 6) und/oder in der Zwischenschicht (5) mindestens ein Aktor, insbesondere ein Pelletierelement, oder Sensor (10), insbesondere ein Temperatursensor und/oder ein Volumenstromsensor vorgesehen ist/sind:

8. Verbundbauteil nach Anspruch 7,
**dadurch gekennzeichnet,**
**dass** der Sensor (10) durch die erste und/oder zweite Fügeschicht (4, 6) durchkontaktiert ist.

## Claims

1. Composite component having a first joining partner (2), having at least one second joining partner (3), and having a first first joining layer (4), which is arranged between the first joining partner (2) and the second joining partner (3), wherein, in addition to the first joining layer (4), at least one second joining layer (6) is provided between the first and second joining partners (2, 3), wherein at least one intermediate layer (5) is arranged between the first and second joining layers (4, 6), wherein the intermediate layer (5) is laterally structured in such a way that structure portions (7) of the intermediate layer (5) are spaced apart laterally, wherein cavities (8) which are interlinked are formed between the structure portions (7), and wherein the first joining partner (2) is an electronics component, in particular a semiconductor element, preferably a power semiconductor element, and/or an in particular populated circuit carrier,
**characterized**
**in that** the first joining layer (4) connects the first joining partner (2) directly to the intermediate layer (5) and the second joining layer (6) connects the second joining partner (3) directly to the intermediate layer (5), in that the first and/or the second joining layer (4, 6) are/is in the form of a sinter layer, adhesive layer, solder layer or elastomer seal material, and in that the second joining partner (3) is a circuit carrier or a heat sink, in particular a base plate, a cooling body or a housing.

2. Composite component according to Claim 1,
**characterized**
**in that** the thermal expansion coefficient of the intermediate layer (5) corresponds at least approximately to the thermal expansion coefficient of the first and/or second joining partner (2, 3).

3. Composite component according to either of the preceding claims,
**characterized**
**in that** the first and/or the second joining layer (4, 6) are/is laterally structured.

4. Composite component according to Claim 3,
**characterized**
**in that** a fluid channel and/or fluid channel network (9) for the passage of a cooling fluid is formed laterally between structure portions (7) of the first and/or second joining layer (4, 6) and/or of the intermediate layer (5).

5. Composite component according to Claim 4,
**characterized**
**in that** means for supplying the fluid channel and/or the fluid channel network (9) with a fluid, in particular a cooling gas or a cooling liquid, are provided.

6. Composite component according to one of the preceding claims,
**characterized**
**in that** the first and/or the second joining layer (4, 6) and/or the intermediate layer (5) are/is microstructured and/or nanostructured.

7. Composite component according to one of the preceding claims,
**characterized**
**in that** at least one actuator, in particular a Peltier element, or sensor (10), in particular a temperature sensor and/or a volume flow sensor, is/are provided in the first and/or second joining layer (4, 6) and/or in the intermediate layer (5).

8. Composite component according to Claim 7,
**characterized**
**in that** the sensor (10) is through-plated through the first and/or second joining layer (4, 6).

## Revendications

1. Composant composite comprenant un premier partenaire d'assemblage (2), au moins un deuxième partenaire d'assemblage (3) et une première couche d'assemblage (4) disposée entre le premier partenaire d'assemblage (2) et le deuxième partenaire d'assemblage (3), au moins une deuxième couche d'assemblage (6) étant prévue, en plus de la première couche d'assemblage (4), entre les premier et deuxième partenaires d'assemblage (2, 3), au moins une couche intermédiaire (5) étant disposée entre les première et deuxième couches d'assemblage (4, 6), la couche intermédiaire (5) étant structurée latéralement de sorte que les parties structurelles (7) de la couche intermédiaire (5) sont espacées latéralement, des cavités (8), qui sont réticulées les unes avec les autres, étant formées entre les parties structurelles (7) et le premier partenaire d'assemblage (2) étant un composant électronique, en particulier un élément semi-conducteur, de préférence un élément semi-conducteur de puissance, et/ou un support de circuit notamment équipé,
**caractérisé en ce que**
la première couche d'assemblage (4) relie le premier partenaire d'assemblage (2) directement à la couche intermédiaire (5) et la deuxième couche d'assemblage (6) relie le deuxième partenaire d'assemblage (3) directement à la couche intermédiaire (5), **en ce que** la première et/ou la deuxième couche d'assemblage (4, 6) sont conçues sous la forme de couche frittée, de couche adhésive, de couche de soudure ou de matériau d'étanchéité élastomère, et **en ce que** le deuxième partenaire d'assemblage (3) est un support de circuit ou un dissipateur de chaleur, en particulier une plaque de base, un corps de refroidissement ou un boîtier.

2. Composant composite selon la revendication 1,
**caractérisé en ce que**
le coefficient de dilatation thermique de la couche intermédiaire (5) correspond au moins approximativement au coefficient de dilatation thermique du premier et/ou du deuxième partenaire d'assemblage (2, 3).

3. Composant composite selon l'une des revendications précédentes,
**caractérisé en ce que**
la première et/ou la deuxième couche d'assemblage (4, 6) sont structurées latéralement.

4. Composant composite selon la revendication 3,
**caractérisé en ce que**
un conduit de fluide et/ou réseau de conduits de fluide (9) destiné au passage d'un fluide de refroidissement est formé latéralement entre des parties structurelles (7) de la première et/ou de la deuxième couche d'assemblage (4, 6) et/ou de la couche intermédiaire (5).

5. Composant composite selon la revendication 4,
**caractérisé en ce que**
des moyens sont prévus pour soumettre le conduit de fluide et/ou le réseau de conduits de fluide (9) à un fluide, en particulier un gaz de refroidissement ou un fluide de refroidissement.

6. Composant composite selon l'une des revendications précédentes,
**caractérisé en ce que**
la première et/ou la deuxième couche d'assemblage (4, 6) et/ou la couche intermédiaire (5) sont micro-structurées et/ou nano-structurées.

7. Composant composite selon l'une des revendications précédentes,
**caractérisé en ce que**
au moins un actionneur, en particulier un élément à effet Peltier, ou un capteur (10), en particulier un capteur de température et/ou un capteur de débit volumétrique, sont prévus dans la première et/ou la deuxième couche d'assemblage (4, 6) et/ou dans la couche intermédiaire (5).

8. Composant composite selon la revendication 7,
**caractérisé en ce que**
le capteur (10) est mis en contact à travers la première et/ou la deuxième couche d'assemblage (4, 6).
